# EUROPEAN PATENT APPLICATION

(11) **EP 1 310 996 A2**
(43) Date of publication of application: **14.05.2003**
(21) Application number: 02257764.7
(22) Date of filing: 08.11.2002
(51) Int. Cl.: H01L 25/18

(54) **Direct interconnect multi-chip module, method for making the same and electronic package comprising same**

(30) Priority: 09.11.2001 US 35518
(71) Applicant: ATI Technologies Inc., Markham, Ontario L3T 7X6 (CA)
(72) Inventor: Chan, Vincent K., ON L4S 2G6 (CA); Ho, Sam, Toronto ON M4K 1X6 (CA); Wang, Chi-Shung David, Fremont CA 94539 (US); Buchner, Gregory C., Los Altos CA 94024 (US)
(74) Representative: Howe, Steven

(57) **Abstract**

A multi-chip module as disclosed herein includes a first semiconductor device, a second semiconductor device and a plurality of device interconnect members. The first semiconductor device is capable of enabling functionality associated with a first circuit segment of an integrated circuit design and includes an array of first device interconnect pads. The second semiconductor device is capable of enabling functionality associated with a second circuit segment of the integrated circuit design and includes an array of second device interconnect pads. Each one of the device interconnect members is electrically connected directly between one of the first device interconnect pads and a corresponding one of the second device interconnect pads.

## Description

The disclosures herein relate generally to multi-chip modules and more particularly to a direct interconnect mult-chip module and method for making the same.

Integrated circuit designs often include a system of discrete functional blocks. Between these discrete functional blocks are circuit-to-circuit connections that join one functional block to one or more other functional blocks. One example of an integrated circuit design with a system of functional blocks is an integrated circuit design with a graphics logic functional block and an embedded Dynamic Random Access memory (DRAM) functional block.

System-on-chip integration is one conventional approach of providing a semiconductor solution for integrated circuit designs including a system of discrete functional blocks. System-on-chip integration involves fabricating a unitary semiconductor device capable of enabling the functionality associated with all of the functional blocks in the integrated circuit design. Because all of the functional blocks of the integrated circuit design are provided on the unitary semiconductor device, communication delay between the various functional blocks is minimal.

However, system-on-chip integration has several limitations. One limitation of system-on-chip integration is that semiconductors associated with system-on-chip integration are generally large, thus adversely affecting manufacturing yield rates and board space. Another limitation of system-on-chip integration is that fabrication operations required for providing the functionality associated with one functional block often adversely affects the unit cost of one or more other functional block that do not require such functional operations. Still another limitation of system-on-chip integration is that performance and manufacturing advantages associated with the use of different semiconductor substrate technologies and semiconductor process technologies is effectively lost.

Traditional multi-chip modules (MCM's) are another conventional approach of providing a semiconductor solution for integrated circuit designs including a system of discrete functional blocks. In traditional MCM's, a plurality of semiconductor devices that are mounted on a common base substrate provide the functionality associated with two or more functional blocks of the integrated circuit design. For example, a first semiconductor device and a second semiconductor device are capable of providing functionality associated with a first functional block and a second functional block, respectively. In this manner, semiconductor substrate technologies and semiconductor fabrication processes are capable of being independently tailored for enhancing performance associated with each functional block. However, the interconnections with the base substrate introduce signal delays, thus adversely affecting performance of the MCM.

Accordingly, a semiconductor solution that at least partially overcomes limitations associated with conventional approaches of enabling functionality of an integrated circuit design including a system of discrete functional blocks is useful.

According to a first aspect of the present invention, a method of fabricating a multi-chip module comprises:
partitioning an integrated circuit design to include a first section and a second section, wherein functionality associated with the first section and functionality associated with the second section jointly enable functionality of the integrated circuit design;
fabricating a first semiconductor device capable of enabling said functionality associated with the first section and including an array of first device interconnect pads;
fabricating a second semiconductor device capable of enabling said functionality associated with the second section and including an array of second device interconnect pads; and
facilitating direct interconnection between each one of the first device interconnect pads and a corresponding one of the second device interconnect pads.

According to a second aspect of the present invention, a multi-chip module comprises:
a first semiconductor device capable of enabling functionality associated with a first section of an integrated circuit design and including an array of first device interconnect pads;
a second semiconductor device capable of enabling functionality associated with a second section of the integrated circuit design and including an array of second device interconnect pads; and
a plurality of device interconnect members, each one of the device interconnect members being electrically connected directly between one of the first device interconnect pads and a corresponding one of the second device interconnect pads.

According to a third aspect of the present invention, there is provided an electronic package comprising a multi-chip module according to the second aspect of the present invention, together with:
an interposer circuit including a dielectric substrate and an array of routing elements attached to the dielectric substrate;
a multi-chip module according to any one off Claims 14 to 20; and
a plurality of package-level interconnect members, each one of said package-level interconnect members being electrically connected between one of the said package-level interconnect pads of the second semiconductor device and a corresponding one of said routing elements of the interposer circuit.

The first and second sections may be a first and second circuit segment, or a first and second functional block.

The present invention will be described, by way of example, with reference to the accompanying drawings, in which:
FIG. 1 is a diagrammatic view depicting an approach for providing a direct interconnect multi-chip module;
FIG. 2 is a fragmented cross-sectional view depicting a direct interconnect multi-chip module;
FIG. 3 is a plan view depicting an array of device interconnect members;
FIG. 4 is a flow chart view depicting a method for constructing a direct interconnect multi-chip module;
FIG. 5 is a fragmented cross-sectional view depicting a wire bond-type electronic package; and,
FIG. 6 is a fragmented cross-sectional view depicting a flip-chip-type electronic package.

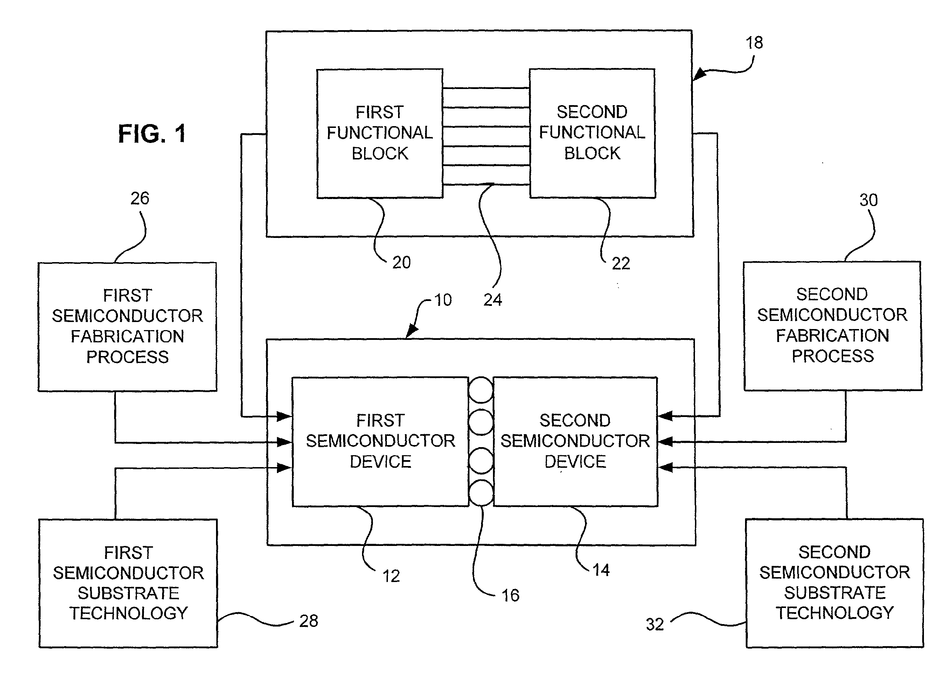

Figures 1 through 6 depict various aspects of a direct interconnect multi-chip module, methods of making such multi-chip module and electronic packages including such multi-chip module, according to one or more embodiments of the disclosures herein. Embodiments of the multi-chip module disclosed herein include a plurality of interconnected semiconductor devices that are each individually capable of enabling functionality associated with a respective circuit segment of an integrated circuit design. The plurality of interconnected semiconductor devices are connected directly to each other rather than through an interposer circuit. Accordingly, multi-chip modules according to the disclosures herein provide a semiconductor solution that at least partially overcomes limitations associated with conventional approaches of enabling functionality of an integrated circuit design including a system of discrete circuit segments.

An approach for constructing a direct interconnect multi-chip module 10 according to an embodiment of the disclosures herein is depicted in FIG. 1. The multi-chip module 10 includes a first semiconductor device 12 and a second semiconductor device 14. A direct interconnection is provided between the first semiconductor device 12 and the second semiconductor device 14 via a plurality of device interconnect members 16. A direct interconnection as disclosed herein refers to interconnections between a plurality of semiconductor devices being made without an interposer circuit. Accordingly, the first semiconductor device 12 and the second semiconductor device 14 are both connected directly to the plurality of device interconnect members 16.

The integrated circuit design 18 includes a first functional block 20 and a second functional block 22. The first functional block 20 is functionally connected to the second functional block 22 via a plurality of circuit interconnections 24. In this manner, the integrated circuit design accomplishes integration of the functionality of the first functional block 20 with the functionality of the second functional block 22.

The multi-chip module 10 is capable of providing functionality associated with the integrated circuit design 18. The first semiconductor device 12 and the second semiconductor device 14 are capable of providing functionality associated with the first functional block 20 and the second functional block 22, respectively, of the integrated circuit design. Because of the direct interconnection between the first semiconductor device 12 and the second semiconductor device 14, performance limiting attributes associated with interconnect impedance are reduced considerably.

The first semiconductor device 12 and the second semiconductor device 14 are capable of being fabricated using different semiconductor fabrication processes and/or different semiconductor substrate technologies. For example, the first semiconductor device 12 is capable of being fabricated using a first semiconductor fabrication process 26 and a first semiconductor substrate technology 28. Similarly, the second semiconductor device 14 is capable of being fabricated using a second semiconductor fabrication process 30 and a second semiconductor substrate technology 32. The ability of separately defining and implementing the process and substrate parameters of the first semiconductor device 12 and the second semiconductor device 14 allow each semiconductor device to be fabricated in a manner that positively impacts yield and performance considerations of the multi-chip module 10.

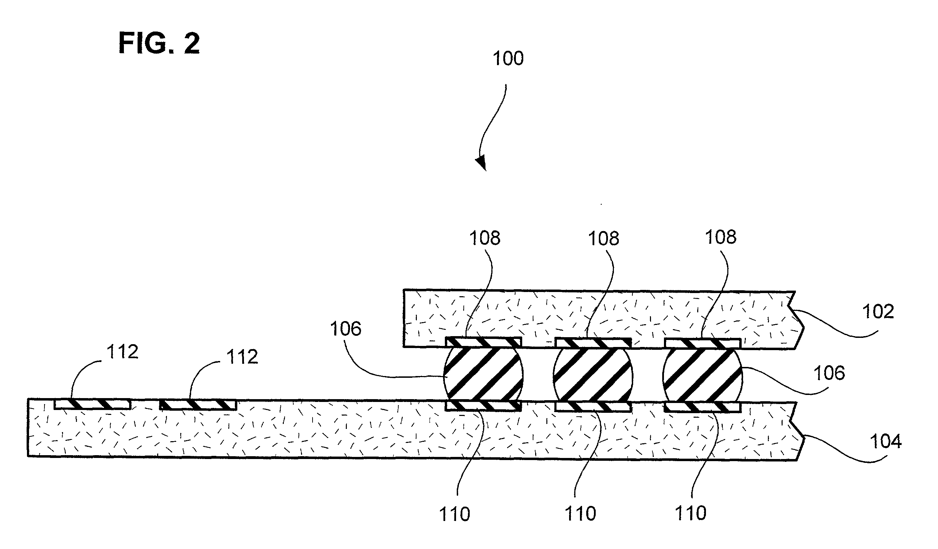

FIG. 2 depicts a direct interconnect multi-chip module 100 according to another embodiment of the disclosures herein. The multi-chip module 100 includes a first semiconductor device 102, a second semiconductor device 104 and a plurality of device interconnect members 106. The first semiconductor device 102 includes an array of first device interconnect pads 108. The second semiconductor device 104 includes an array of second device interconnect pads 110 and a plurality of package-level interconnect pads 112.

Each one of the device interconnect members 106 is electrically connected directly between one of the first device interconnect pads 108 and a corresponding one of the second device interconnect pads 110. In one embodiment of the device interconnect members 106, each one of the device interconnect members 106 is a solder-type interconnect member. A solder bump and a solder ball are examples of the solder-type interconnect member.

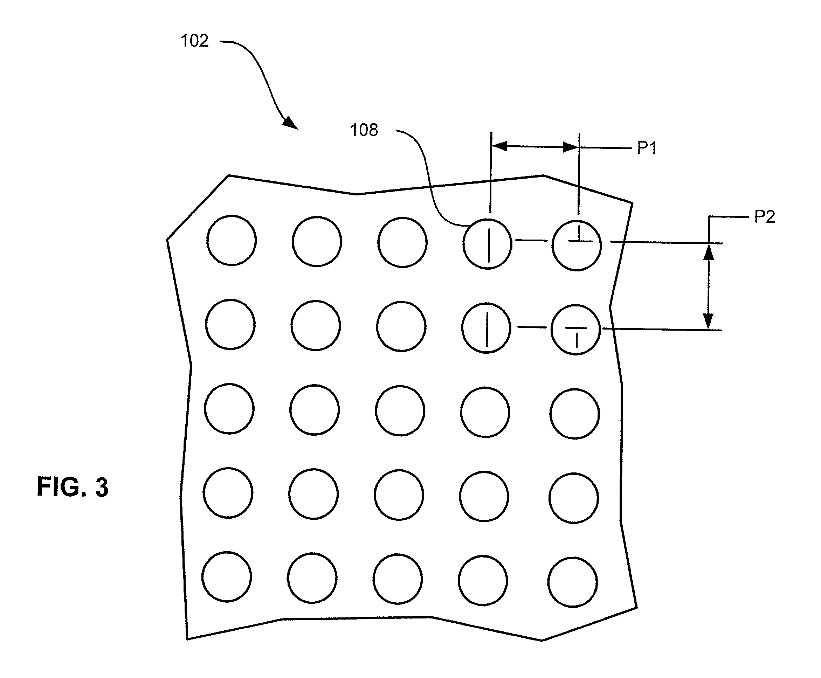

Referring to FIG. 3, the array of first device interconnect pads 108 of the first device 102 has a first pitch P and a second pitch P2. The first pitch P1 is preferably, but not necessarily, the same as the second pitch P2. In one embodiment of the first semiconductor device, the first pitch P1 and the second pitch P2 are about 75 micrometers. It is contemplated herein that the first pitch P1 and the second pitch P2 may be about 75 micrometers, greater than about 75 micrometers or less than about 75 micrometers. The array of second device interconnect pads 110 of the second semiconductor device 104 has a respective first pitch and second pitch essentially the same as the first semiconductor device 102.

An advantage of multi-chip modules according to embodiments the disclosures herein, such as the multi-chip module 100, is that the device interconnect members serve as an effective via layer. As disclosed herein, the first pitch P1 of the first semiconductor device 102 and the second pitch P2 of the second semiconductor device 104 result in the array of first device interconnect pads 108 and the array of second device interconnect pads 110, respectively, having a high density (i.e. closely spaced). Accordingly, a short and direct interconnection between the first semiconductor device 102 and the second semiconductor device 104 is provided, thus reducing interconnect delays associated with interconnect impedance (i.e. interconnect inductance and interconnect resistance). By reducing interconnect delays, communication bandwidth between the first semiconductor device 102 and the second semiconductor device 104 is increased.

The first semiconductor device 102 is fabricated in a manner allowing it to be capable of enabling functionality associated with a first circuit segment of an integrated circuit design. Similarly, the second semiconductor device 104 is fabricated in a manner allowing it to be capable of enabling functionality associated with a second circuit segment of the integrated circuit design. In one embodiment of the first semiconductor device 102 and the second semiconductor device 104, the first semiconductor device 102 and the second semiconductor device 104 are capable of enabling functionality associated with a first functional block of the integrated circuit design and a second functional block of the integrated circuit design, respectively.

In a first example, the first semiconductor device 102 is capable of providing memory functionality (e.g. a DRAM device, buffer, cache, etc.) and the second semiconductor device 104 is capable of providing logic functionality (e.g. a logic device). In a second example, the first semiconductor device 102 is capable of providing radio frequency (RF) communications functionality (e.g. a RF signal transponder) and the second semiconductor device 104 is capable of providing logic functionality. In a third example, the first semiconductor device 102 is capable of providing digital functionality (e.g. a graphics core) and the second semiconductor device 104 is capable of providing analog functionality (e.g. display subsystem).

It is contemplated herein that the functionality provided by the first semiconductor device 102 and by the second semiconductor device 104 is configured in a manner where optimized and/or desired operation of the multi-chip module 100 is provided. For example, in some applications, it may be advantageous for the first semiconductor device 102 to be capable of providing analog functionality (e.g. display subsystem) and for the second semiconductor device 104 to be capable of providing digital functionality (e.g. a graphics core). Functionality of the first semiconductor device 102 and by the second semiconductor device 104 is dictated by specific applications and not by examples disclosed herein.

Another advantage of multi-chip modules according to embodiments the disclosures herein, such as the multi-chip module 100, is that functionality associated with the first circuit segment and the second circuit segment may be enabled via different types of known and newly discovered semiconductor substrate technologies and/or semiconductor fabrication processes. In this manner, a specific circuit segment (e.g. functional block) can be matched with a particular semiconductor substrate technologies and/or semiconductor fabrication processes for enhancing performance, reducing unit cost, etc. CMOS (complementary metal oxide semiconductor), Bi-Polar, and Silicon Germanium are examples of known semiconductor substrate technologies. A DRAM semiconductor fabrication process and a logic semiconductor fabrication process are examples of known semiconductor fabrication processes.

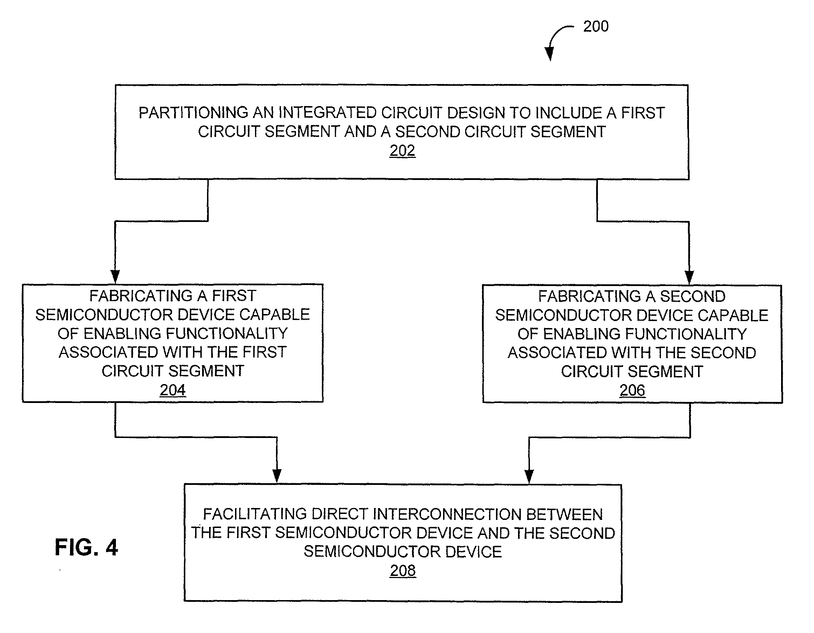

FIG. 4 depicts a method 200 according to another embodiment of the disclosures herein. The method 200 is capable of fabricating a multi-chip module according to the disclosures herein. In the method 200, an operation 202 is performed for partitioning an integrated circuit design to include a first circuit segment and a second circuit segment. A first functional block and a second functional block are examples of the first and the second circuit segments, respectively. A memory functional block and a logic functional block are examples of the first functional block and the second functional block, respectively.

In at least one embodiment of the method 200, the operation 202 for partitioning the integrated circuit design includes partitioning the integrated circuit design such that the first circuit segment is associated with a first semiconductor substrate technology and the second circuit segment is associated with a second semiconductor substrate technology. Also in at least one embodiment of the method 200, partitioning the integrated circuit design includes partitioning the integrated circuit design such that the first circuit segment is associated with a first semiconductor fabrication process and the second circuit segment is associated with a second semiconductor fabrication process.

After performing the operation 202 for partitioning the integrated circuit design, an operation 204 is performed for fabricating a first semiconductor device capable of enabling functionality associated with the first circuit segment and including an array of first device interconnect pads. Also after performing the operation 202 for partitioning the integrated circuit design, an operation 206 is performed for fabricating a second semiconductor device capable of enabling functionality associated with the second circuit segment and including an array of second device interconnect pads. In at least one embodiment of the method 200, fabricating the first semiconductor device and the second semiconductor device includes fabricating the first semiconductor device and the second semiconductor device for being capable of enabling functionality associated with a first functional block and a second functional block, respectively, of the integrated circuit design. Fabricating the first semiconductor device to be a DRAM device and the second semiconductor device to be a logic device is an example of fabricating the first semiconductor device and the second semiconductor device for being capable of enabling functionality associated with a first functional block and a second functional block, respectively, of the integrated circuit design.

In at least one embodiment of the method 200, the operations (204, 206) for fabricating the first semiconductor device and fabricating the second semiconductor device include fabricating the first semiconductor device using a first semiconductor substrate technology and fabricating the second semiconductor device using a second semiconductor substrate technology. Also in at least one embodiment of the method 200, the operations (204, 206) for fabricating the first semiconductor device and fabricating the second semiconductor device include fabricating the first semiconductor device using a first semiconductor fabrication process and fabricating the second semiconductor device using a second semiconductor fabrication process. For example, a particular integrated circuit design associated with a multi-chip module as disclosed herein includes a DRAM circuit segment and a logic circuit segment. In such an example, it is advantageous from a yield, a unit cost and/or a performance perspective to employ different semiconductor substrate technologies and/or semiconductor fabrication processes for the semiconductor enabling DRAM functionality and for the semiconductor enabling logic functionality.

After performing the operations (204, 206) for fabricating the first semiconductor device and the second semiconductor device, an operation 208 is performed for facilitating direct interconnection between the first semiconductor device and the second semiconductor device. In at least one embodiment of the operation 208 for facilitating direct interconnection between the first semiconductor device and the second semiconductor device, facilitating direct interconnection includes facilitating direct interconnection between each one of the first device interconnect pads and a corresponding one of the second device interconnect pads. Attaching a solder ball or a solder bump between each one of the first device interconnect pads and a corresponding one of the second device interconnect pads is an example of facilitating direct interconnection between the first semiconductor device and the second semiconductor device. Forming a connection with a solder bump or a solder ball is an example of forming a solder-type interconnect.

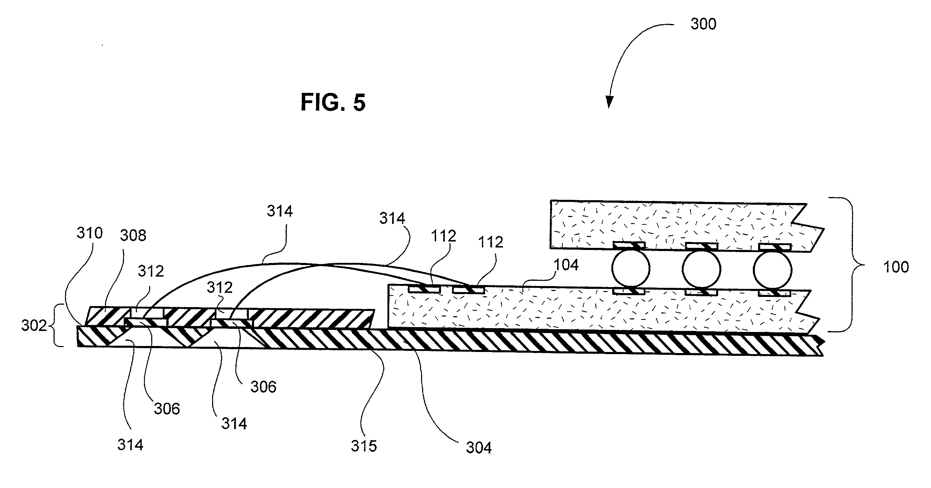

FIG. 5 depicts a wire bond-type electronic package 300 according to another embodiment of the disclosures herein. The electronic package 300 includes an interposer circuit 302 and the multi-chip module 100 disclosed above in reference to FIG. 2. Commercially available flexible ball grid array circuits and plastic ball grid array circuits capable of enabling wire bond-type connections to a semiconductor die or multi-chip module are examples of the interposer circuit 302.

The interposer circuit 302 includes a dielectric substrate 304, an array of solder ball pads 306, and a solder mask 308. The array of solder ball pads 306 are attached to a first surface 310 of the dielectric substrate 304. Each one of the solder ball pads 306 is an example of a routing element. The solder mask 308 is formed on the first surface 310 and includes a window 312 therein adjacent to each one of the solder ball pads 306. At least a portion of each one of the solder ball pads 306 is accessible through a corresponding one of the windows 312.

A solder ball via 314 is formed in the dielectric substrate 304 adjacent to each one of the solder ball pads 306 for enabling access to each one of the solder ball pads 306 through the dielectric substrate 304. Accordingly, a solder ball (not shown) is capable of being attached to each one of the solder ball pads 306 through the corresponding one of the solder ball vias 314 adjacent to a second side 315 of the dielectric substrate 304.

Various aspects of interposer circuits as discussed herein are well known in the art. It is recognized herein that interposer circuits, such as the interposer circuit 302, may include other known elements (e.g. a stiffener, reference voltage plane, etc.) and newly discovered elements. Such other elements and the resulting utility and benefits in combination with the disclosures herein will be apparent to one skilled in the related art in view of the disclosures herein.

The multi-chip module 100 is mounted on and electrically connected to the interposer circuit 302. Attaching the multi-chip module 100 to the interposer circuit 302 using a commercially available die attached adhesive is one example of a technique for mounting the multi-chip module 100 on the interposer circuit 302. A wirebond conductor 316 is connected between each one of the package-level interconnect pads 112 of the multi-chip module 100 and a corresponding one of the routing elements 306. The wire bond conductor 316 is an example of a package-level interconnect member. Techniques for attaching wire bond conductors between a semiconductor device and an interposer circuit are well known in the art.

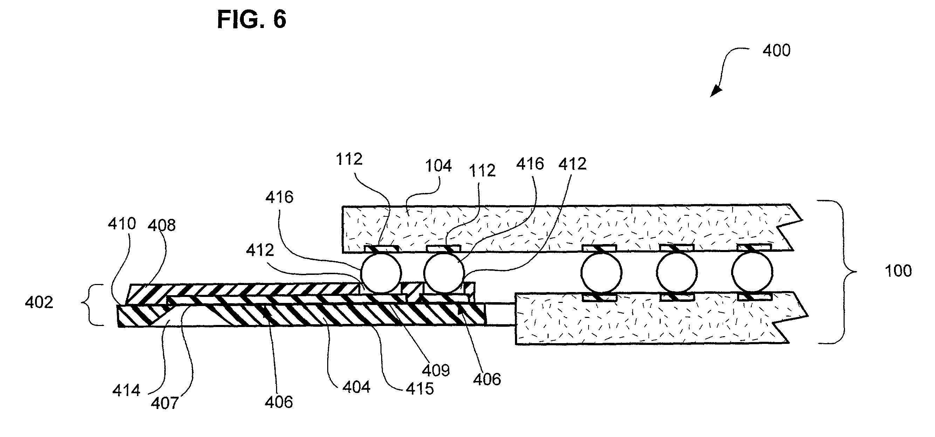

FIG. 6 depicts a flip-chip-type electronic package 400 according to another embodiment of the disclosures herein. The electronic package 400 includes an interposer circuit 402 and the multi-chip module 100 disclosed in reference to FIG. 2. Commercially available flexible ball grid array circuits and plastic ball grid array circuits capable of enabling a flip-chip-type connection to a semiconductor die or module are examples of the interposer circuit 402.

The interposer circuit 402 includes a dielectric substrate 404, an array of routing traces 406, and a solder mask 408. The array of routing traces 406 are attached to a first surface 410 of the dielectric substrate 404. The routing traces 406 each include a board-level interconnect pad 407 and a die-level interconnect pad 409. The routing traces 406 are examples of routing elements. The solder mask 408 is formed on the first surface 410 and includes a window 412 therein adjacent to each one of the die-level interconnect pads 409. At least a portion of each one of the die-level interconnect pads 409 is accessible through a corresponding one of the windows 412.

A solder ball via 414 is formed in the dielectric substrate 404 adjacent to each board-level interconnect pad 407 for enabling access to each one of the board-level interconnect pad 407 through the dielectric substrate 404. Accordingly, a solder ball (not shown) is capable of being attached to each one of the routing traces 406 through the corresponding one of the solder ball vias 414 adjacent to a second side 415 of the dielectric substrate 404.

Various aspects of interposer circuits as discussed herein are well known in the art. It is recognized herein that interposer circuits, such as the interposer circuit 402, may include other known elements (e.g. a stiffener, reference voltage plane, etc.) and newly discovered elements. Such other elements and the resulting utility and benefits in combination with the disclosures herein will be apparent to one skilled in the related art in view of the disclosures herein.

The multi-chip module 100 is mounted on and electrically connected to the interposer circuit 402. Attaching the multi-chip module 100 to the interposer circuit 402 using a commercially available die attached adhesive is one example of a technique for mounting the multi-chip module 100 on the interposer circuit 402. A solder bump 416 is connected between each one of the package-level interconnect pads 112 of the multi-chip module 100 and a corresponding one of the die-level interconnect pads 409 of the routing traces 406. The solder bump 416 and a solder ball are examples of a package-level interconnect member. Techniques for connecting solder bumps and solder balls between a semiconductor device and an interposer circuit are well known in the art.

Multi-chip modules and method of making multi-chip modules according to embodiments of the disclosures herein provide a number of advantages relative to conventional semiconductor solutions for enabling functionality of an integrated circuit design including a system of discrete circuit segments (e.g. functional blocks). One advantage is that the individual semiconductors of such multi-chip modules are relatively small, thus positively impacting manufacturing yield rates and board design. Another advantage is that fabrication operations required for providing the functionality associated with one circuit segment of an integrated circuit design do not adversely affects the yield and performance attributes of other discrete circuit segments of the integrated circuit design. Still another advantage is that performance and manufacturing benefits associated with the use of different semiconductor substrate technologies and semiconductor fabrication processes positively impact cost and performance attributes of such multi-chip modules. Yet another advantage is that the benefits of conventional multi-chip modules (MCM's) are provided without the limitations associated with conventional multi-chip modules.

Accordingly, the specification and figures herein are to be regarded in an illustrative rather than in a restrictive sense, and all such modifications and their equivalents are intended to be included within the scope of the present invention. Benefits, other advantages, and solutions to problems have been described above with regard to specific embodiments. However, the benefits, advantages, solutions to problems, and any elements that may cause any benefit, advantage, or solution to occur or become more pronounced are not to be construed as critical, required, or essential features or elements of any or all of the claims.

## Claims

1. A method of fabricating a multi-chip module (100), comprising:
partitioning (202) an integrated circuit design to include a first section and a second section, wherein functionality associated the first section and functionality associated with the second section jointly enable functionality of the integrated circuit design;
fabricating (204) a first semiconductor device (12; 102) capable of enabling said functionality associated with the first section and including an array of first device interconnect pads (108);
fabricating (206) a second semiconductor device (14; 104) capable of enabling said functionality associated with the second section and including an array of second device interconnect pads (110); and
facilitating (208) direct interconnection between each one of the first device interconnect pads (110) and a corresponding one of the second device interconnect pads (110).

2. The method of Claim 1, wherein partitioning (202) the integrated circuit design to include a first section and a second section includes defining the first section as a first functional block (20), and the second section as a second function block (22).

3. The method of Claim 1, wherein partitioning (202) the integrated circuit design to include a first section and a second section includes defining the first section as a first circuit segment and the second section as a second circuit segment.

4. The method of claim 3, wherein partitioning (202) the integrated circuit design to include a first circuit segment and a second circuit segment includes defining a first functional block (20) of the integrated circuit design and a second functional block (22) of the integrated circuit design.

5. The method of claim 2 or claim 4, wherein defining the first functional block (20) and the second functional block (22) includes defining a memory functional block and a logic functional block, respectively.

6. The method of any one of the preceding claims, wherein partitioning (202) the integrated circuit design to include a first section and a second section includes partitioning the integrated circuit design such that the first section is associated with a first type of semiconductor substrate and the second section is associated with a second type of semiconductor substrate.

7. The method of any one of the preceding claims, wherein partitioning (202) the integrated circuit design to include a first section and a second section includes partitioning the integrated circuit design such that the first section is associated with a first semiconductor fabrication process and the second section is associated with a second semiconductor fabrication process.

8. The method of any one of the preceding claims, wherein:
fabricating (204) the first semiconductor device (12; 102) includes fabricating the first semiconductor device (12; 102) for being capable of enabling functionality associated with a first functional block (20) of the integrated circuit design; and
fabricating (206) the second semiconductor device (14; 104) includes fabricating the second semiconductor device (14; 104) for being capable of enabling functionality associated with a second functional block (22) of the integrated circuit design.

9. The method of any one of the preceding claims, wherein:
fabricating the first semiconductor device (12; 102) includes fabricating a DRAM device; and
fabricating the second semiconductor device (14; 104) includes fabricating a logic device.

10. The method of any one of the preceding claims, wherein:
fabricating (204) the first semiconductor device (12; 102) includes fabricating the first semiconductor device (12; 102) from a first type of semiconductor substrate; and
fabricating (206) the second semiconductor device (14; 104) includes fabricating the second semiconductor device (14; 104) from a second type of semiconductor substrate.

11. The method of any one of the preceding claims, wherein:
fabricating (204) the first semiconductor device (12; 102) includes fabricating the first semiconductor device (12; 102) using a first semiconductor fabrication process; and
fabricating (206) the second semiconductor device (14; 104) includes fabricating the second semiconductor device (14; 104) using a second semiconductor fabrication process.

12. The method of any one of the preceding claims, wherein facilitating (208) direct interconnection between each one of the first device interconnect pads (108) and a corresponding one of the second device interconnect pads (110) includes forming a solder-type interconnect between each one of the first device interconnect pads (108) and the corresponding one of the second device interconnect pads (110).

13. The method of claim 12, wherein forming the solder-type interconnect includes forming a solder bump or a solder ball interconnect.

14. A multi-chip module, comprising:
a first semiconductor device (12; 102) capable of enabling functionality associated with a first section of an integrated circuit design and including an array of first device interconnect pads (108);
a second semiconductor device (14; 104) capable of enabling functionality associated with a second section of the integrated circuit design and including an array of second device interconnect pads (110); and
a plurality of device interconnect members (16; 106), each one of the device interconnect members (16; 106) being electrically connected directly between one of the first device interconnect pads (108) and a corresponding one of the second device interconnect pads (110).

15. A multi-chip module according to claim 14, wherein the first section is a first circuit segment, and the second section is a second circuit segment.

16. A multi-chip module according to claim 14 or claim 15, in which the first section is a first functional block, and the second section is a second functional block.

17. The multi-chip module of any one of claims 14 to 16, wherein:
the first semiconductor device is a DRAM device; and
the second semiconductor device is a logic device.

18. The multi-chip module of any one of claims 14 to 17, wherein:
the first semiconductor device is made from a first type of semiconductor substrate; and
the second semiconductor device is made from a second type of semiconductor substrate.

19. The multi-chip module of any one of claims 14 to 18, wherein each one of the device interconnect members (16; 106) is a solder-type interconnect member.

20. The multi-chip module of claim 19, wherein the solder-type interconnect member is a solder bump or a solder ball.

21. An electronic package, comprising:
an interposer circuit including a dielectric substrate and an array of routing elements attached to the dielectric substrate;
a multi-chip module according to any one of claims 14 to 20; and
a plurality of package-level interconnect members, each one of said package-level interconnect members being electrically connected between one of the said package-level interconnect pads of the second semiconductor device and a corresponding one of said routing elements of the interposer circuit.

22. The electronic package of claim 21, wherein:
the interposer circuit is a flip-chip interposer circuit; and
each one of said package-level interconnect members is a solder-type interconnect member.

23. The electronic package of claim 21, wherein:
the interposer circuit is a wire-bond interposer circuit; and
each one of said package-level interconnect members is a conductive wire.
